(19) Europäisches Patentamt
European Patent Office
Office européen des brevets

(11) **EP 3 629 405 A1**

(12) **EUROPÄISCHE PATENTANMELDUNG**

(43) Veröffentlichungstag:
01.04.2020 Patentblatt 2020/14

(21) Anmeldenummer: 19196978.1

(22) Anmeldetag: 12.09.2019

(51) Int Cl.:
H01M 4/36 (2006.01)     H01M 4/62 (2006.01)
H01M 4/58 (2010.01)     H01M 4/75 (2006.01)
H01M 4/13 (2010.01)     H01M 4/134 (2010.01)
H01M 10/0525 (2010.01)   H01M 4/04 (2006.01)

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**
Benannte Validierungsstaaten:
**KH MA MD TN**

(30) Priorität: **27.09.2018   EP 18197255**

(71) Anmelder: **Siemens Aktiengesellschaft
80333 München (DE)**

(72) Erfinder:
• **Doye, Christian
  13156 Berlin (DE)**
• **Jensen, Jens Dahl
  14050 Berlin (DE)**
• **Krüger, Ursus
  14089 Berlin (DE)**
• **Winkler, Gabriele
  13587 Berlin (DE)**

(54) **LITHIUM-IONEN-AKKUMULATOR UND MATERIAL SOWIE VERFAHREN ZUM HERSTELLEN DESSELBEN**

(57)   Die Erfindung betrifft ein Material für einen Lithium-Ionen-Akkumulator sowie einen aus diesem Material gefertigten Lithium-Ionen-Akkumulator sowie ein Verfahren zur Fertigung desselben. Erfindungsgemäß ist vorgesehen, dass das Material aus elektrisch leitfähigen Mikropartikeln oder Nanopartikel besteht und diese mit funktionalen Schichten zur Ausbildung der kathodischen beziehungsweise der anodischen Funktion des Akkumulators ausgestattet sind. Beispielsweise können diese Partikel aus Titanoxidnadeln 16 bestehen und aufeinanderfolgende Lagen einer Beschichtung aus einem Metall 53, Germanium 50, Bor 51 und Lithium 52 aufweisen. Kathodische Partikel können mit einer Schicht aus einem Lithiummetalloxid oder einem Lithiummetallphosphat beschichtet sein. Das erfindungsgemäße Material kann vorteilhaft beispielsweise in einer Polymermatrix, die gleichzeitig den Elektrolyten des Akkumulators ausbildet, verarbeitet werden, wodurch vorteilhaft kostengünstig Akkumulatoren mit hohe elektrischen Entladestromdichten und geringem Gewicht erzeugt werden können.

## FIG 12

EP 3 629 405 A1

**Beschreibung**

Die Erfindung betrifft ein Material für einen Lithium-Ionen-Akkumulator (im Folgenden auch kurz als Akkumulator bezeichnet). Außerdem betrifft die Erfindung einen Lithium-Ionen-Akkumulator mit einem solchen Material und ein Verfahren zum Herstellen eines Lithium-Ionen-Akkumulators.

Lithium-Ionen-Akkumulatoren werden in modernen transportablen elektronischen Geräten (mobile Telefone, Tablets, Notebooks), sowie in der modernen Fahrzeugtechnik (Auto, Flugzeug) und auch in der Raumfahrttechnik eingesetzt. Gegenüber anderen Batterietypen weisen Lithium-Ionen-Akkumulatoren eine hohe Energiedichte, eine hohe Leistungsdichte und eine hohe Nennspannung, sowie eine höhere Anzahl von möglichen Ladezyklen auf, bevor der Akkumulator an Leistung und Kapazität verliert. Zum Betreiben von Autos und Flugzeugen wäre eine weitere Zunahme der Energiedichte wünschenswert, um einerseits das Gewicht der Akkumulatoren zu reduzieren und andererseits die Reichweite der genannten Verkehrsmittel zu verlängern.

Insbesondere für das Anodenmaterial werden heute zum Beispiel Graphit, Germanium, Silizium, Bor, Wolfram oder Wolframcarbid in einer Hochenergie-Kugelmühle unter Schutzgas mit 1000 bis 1500 RPM (Umdrehungen pro Minute) gemahlen. Dabei entstehen Legierungen aus Germanium-Kohlenstoff-Bor, Silizium-Kohlenstoff-Bor, Germanium-Kohlenstoff-Bor-Wolfram, Germanium-Silizium-Kohlenstoff-Bor oder Germanium-Kohlenstoff-Wolfram. Die Partikel haben nach dem Mahlen eine Größe von 20 bis 100 nm. Die Legierungen werden mit einem leitfähigen Agent (Graphit, Graphen, Carbon-Nano-Tubes) in einem Bindemittel (Polyvinylidenflourid, PVDF) verarbeitet und dann auf einen Stromkollektor aufgebracht.

Das Kathodenmaterial kann über eine lowcost Sol-Gel-Methode synthetisiert werden. Dazu werden stöchiometrische Lösungsmengen von Lithiumcitrat $C_6H_5LiO_7$ mit Wasser, Mangan(II)acetat $(CH_3COO)_2Mn$ mit Wasser und Nickel-(II) acetat $(CH_3COO)_2Ni$ mit Wasser unter kräftigem Rühren gemischt. Nach gründlichem Mischen wird die Precursor-Lösung in einer Mikrowelle getrocknet, bis ein transparentes Gel entsteht. Nach dem Mahlen wird das Gel in einen Rohrofen transferiert und auf 350 °C für zwei Stunden erhitzt. Das erhaltene Produkt wird mit Ethanol gemischt und dann in einer Kugelmühle 6 Stunden gemahlen. Anschließend wird die resultierende Lösung in einem Sprühtrockner getrocknet. Die Zulufttemperatur beträgt 180 °C und die Ablufttemperatur 90 °C. Anschließend wird das sprühgetrocknete Pulver bei 750 °C für 10 Stunden in umgebender Atmosphäre gesintert. Man erhält ein Ni-gedoptes Lithiummanganoxid-Pulver ($LiMn_2O_4$). Um die elektrochemische Performance der Li-Ionen-Batterie zu verbessern, können die mesoporösen Li-$NiMn_2O_4$-Pulverpartikel noch mit $NiCo_2O_4$ beschichtet werden. Dazu wird Nickelnitrat und Kobalt(I)nitrat in deionisiertem Wasser gelöst, um eine homogene Lösung zu bilden. Dann wird das $LiNiMn_2O_4$-Pulver zur Metallnitratlösung hinzugefügt und unter Ultraschalleinwirkung drei Stunden gerührt, um eine homogene Suspension zu erhalten. Anschließend wird eine nicht stöchiometrische Lösungsmenge von Essigsäure in die Suspension langsam unter kräftigem Rühren zugegeben und bei Raumtemperatur für 30 Minuten gealtert. Nach dem Filtrieren, Waschen, Trocknen und einer Wärmebehandlung bei 250 °C in umgebener Atmosphäre erhält man mit $NiCo_2O_2$ beschichtetes Li-$NiMn_2O_4$-Pulver. Zur Präparation einer Kathode wird das aktive Pulvermaterial mit Acetylenblack und Polyvinylidenfluorid (PVDF) gründlich gemischt und in N-Methyl-Pyrrolidon gelöst, um einen homogenen Slurry zu erhalten. Der gebildete Slurry wird auf einer Aluminiumfolie durch Brush-Plating aufgetragen und in einem Vakuumofen bei 120°C 12 Stunden getrocknet, um eine Kathode zu bilden.

Die Aufgabe der Erfindung besteht darin, ein Material für einen Lithium-Ionen-Akkumulator dahingehend zu verbessern, dass dieser Akkumulator eine hohe Leistungsdichte bei der Stromentnahme bei gleichzeitig einem geringen Gewicht ermöglicht (geringes Leistungsgewicht). Außerdem ist es Aufgabe der Erfindung, einen Lithium-Ionen-Akkumulator anzugeben, der dieses Eigenschaftsprofil aufweist. Zuletzt ist es Aufgabe der Erfindung, ein Verfahren zur Herstellung eines solchen Lithium-Ionen-Akkumulators anzugeben, wobei der hergestellte Akkumulator die oben genannten Eigenschaften aufweist.

Diese Aufgabe wird mit dem eingangs angegebenen Anspruchsgegenstand (Material) erfindungsgemäß dadurch gelöst, dass dieses zumindest an ihrer Oberfläche elektrisch leitfähige Mikropartikel oder Nanopartikel aufweist, welche mit mindestens einer funktionalen Schicht zur Ausbildung der kathodischen oder anodischen Funktion des Lithium-Ionen-Akkumulators beschichtet ist.

Zur Steigerung der Energiedichte müssen die Oberflächen der energiespeichernden Materialien vergrößert werden. Eine Vergrößerung der Oberfläche kann einerseits durch die Form- und Strukturgestaltung der Elektroden, dem Träger des elektrochemisch aktiven Materials, und andererseits durch die Verkleinerung der aktiven Materialteilchen, die an der Bildung der Elektroden beteiligt sind, in den nanoskaligen bis atomaren Bereich erreicht werden. Die Miniaturisierung kann erfindungsgemäß durch Atomlagenabscheidung der energiespeichernden Materialien auf eine nanoskalige Trägersubstanz realisiert werden.

Dass die Mikropartikel oder Nanopartikel zumindest an ihrer Oberfläche elektrisch leitfähig sein sollen, kann dadurch erreicht werden, dass die an sich nicht leitfähigen Partikel (das heißt Mikropartikel oder Nanopartikel) mit einer elektrisch leitfähigen Beschichtung versehen werden. Alternativ ist es selbstverständlich auch möglich, dass das Material der Mikropartikel oder Nanopartikel (im Folgenden zusammenfassend einfach als Partikel bezeichnet) selbst elektrisch leitfähig ist, was eine zusätzliche Beschichtung mit einem elektrisch leitfähigen Material erübrigt.

Ausschlaggebend ist erfindungsgemäß jedoch mindestens eine funktionale Schicht auf der Oberfläche der Partikel, welche entweder die kathodische oder die anodische Funktion des Lithium-Ionen-Akkumulators ausmacht. Damit sind diese Partikel vorteilhaft geeignet, um zur Herstellung eines Akkumulators weiterverarbeitet zu werden. Dabei ermöglicht die Verwendung der Partikel einen vorteilhaften sehr kompakten Aufbau des Akkumulators, weswegen dieser im Verhältnis zu seiner Kapazität ein geringes Eigengewicht aufweist. Gleichzeitig kann die zu entnehmende Stromdichte vergleichsweise hoch gewählt werden (hierzu im Folgenden noch mehr). Ein Akkumulator, der aus dem erfindungsgemäßen Material hergestellt wird, löst damit die oben angegebene Aufgabe.

Gemäß einer Ausgestaltung der Erfindung ist vorgesehen, dass die Mikropartikel oder Nanopartikel aus Graphit, elektrisch leitfähig beschichtetem Titanoxid, Carbon-Nanotubes oder Graphen-Nanoplatelets bestehen.

Die vorgeschlagenen Materialien für die Partikel sind vorteilhaft als Stand der Technik verfügbar und können zu vertretbaren Preisen beschafft werden. Zur Erzeugung des Materials müssen diese anschließend noch mit der funktionalen Schicht beschichtet werden. Damit ist vorteilhaft eine kostengünstige Herstellung des Materials möglich, welches anschließend zu Akkumulatoren mit dem geforderten Anforderungsrofil (geringes Leistungsgewicht, hohe Leistungsdichte bei der Entladung) ausgestattet sein können.

Gemäß einer Ausgestaltung der Erfindung ist vorgesehen, dass die Mikropartikel oder Nanopartikel die Form von Nadeln, Flakes oder Plättchen haben.

Wenn die Mikropartikel nadelförmig sind oder die Form von Flakes oder Plättchen haben, wird vorteilhaft im Verhältnis zu deren Masse die Oberfläche vergleichsweise groß. Die Oberfläche steht wiederum zur Beschichtung mit der kathodischen oder anodischen funktionalen Schicht zur Verfügung. Dadurch ist es möglich, vergleichsweise viel des funktionalen Materials auf der Oberfläche der Partikel unterzubringen. Hierdurch wird insbesondere die Leistungsdichte der Stromentnahme erhöht, da der Strom über eine größere Fläche abgegeben werden kann.

Gemäß einer Ausgestaltung der Erfindung ist vorgesehen, dass mindestens eine funktionale Schicht eine Dicke von weniger als 500 nm aufweist, vorzugsweise die Dicke einer Atomlage aufweist.

Je dünner die funktionale Schicht ist, desto besser kann das Material im Verhältnis zu seiner eingesetzten Masse genutzt werden. Dies wirkt sich ebenfalls vorteilhaft auf die Leistungsdichte und das Gesamtgewicht des Akkumulators aus. Insbesondere ist es von besonderem Vorteil, wenn die funktionale Schicht die Dicke einer Atomlage aufweist. Hierbei können vorteilhaft bei der Entladung des Akkumulators auch Tunneleffekte genutzt werden, wodurch die Stromdichte des entnehmbaren Stroms weiter ansteigt. Zur Abscheidung einzelner Atomlagen auf den Partikeln kann ein ALD-Verfahren verwendet werden (hierzu im Folgenden noch mehr).

Gemäß einer Ausgestaltung der Erfindung ist vorgesehen, dass die Mikropartikel oder Nanopartikel für die Anode des Lithium-Ionen-Akkumulators vorgesehen sind, wobei diese mehrere Schichten aufweisen, in der folgenden Reihenfolge von innen nach außen bestehend aus

- Germanium,
- Bor oder Boroxid,
- Lithium.

Auf die angegebene Weise wird vorteilhaft das Anodenmaterial hergestellt. Hierbei wird das elektrisch leitfähige Trägermaterial Germanium beispielsweise auf den elektrisch isolierenden Titanoxidnadeln abgeschieden. Es folgt Bor oder Boroxid und darauf Lithium, wobei unterschiedliche Metallprecursoren verwendet werden können, aus der Dampfphase abgeschieden werden (ALD-Verfahren, hierzu im Folgenden noch mehr). Hierdurch entstehen vorteilhaft sehr dünne Schichten mit einem hohen Wirkungsgrad in Bezug auf die Masse des eingesetzten Materials.

Gemäß einer Ausgestaltung der Erfindung ist vorgesehen, dass die Mikropartikel oder Nanopartikel für die Kathode eines Lithium-Ionen-Akkumulators vorgesehen sind, wobei diese aus einem Lithiummetalloxid oder Lithiummetallphosphat besteht.

Bei Akkumulatoren auf Lithium-Ionen-Basis wird als Kathodenmaterial üblicherweise ein Lithiummetalloxid oder Lithiummetallphosphat benötigt. Dieses Material kann vorteilhaft ebenfalls auch auf den Partikeln abgeschieden werden, um das Anodenmaterial zu bilden. Die dünnen Schichten auf den Partikeln ermöglichen aufgrund der großen Oberfläche einen schnellen Ablauf der chemischen Prozesse, was den Vorteil einer hohen möglichen Energiedichte bei der Stromentnahme mit sich bringt.

Die Aufgabe wird alternativ mit dem eingangs angegebenen Anspruchsgegenstand (Akkumulator) erfindungsgemäß auch dadurch gelöst, dass die Anode aus dem erfindungsgemäßen Material als Anodenmaterial und die Kathode aus dem erfindungsgemäßen Material als Kathodenmaterial gebildet ist.

Dadurch, dass das Material, welches oben näher beschrieben wurde, als Anodenmaterial und als Kathodenmaterial Verwendung findet, ist es möglich, einen Lithium-Ionen-Akkumulator zur Verfügung zu stellen, der bei gleichzeitig hoher Kapazität und Leistungsdichte bei der Stromentnahme ein vergleichsweise geringes Eigengewicht aufweist. Die erfindungsgemäßen Akkumulatoren eignen sich daher insbesondere als Antriebsbatterie beispielsweise für Fahrzeuge zu Lande und im Wasser sowie Flugzeuge. Insbesondere in der Luftfahrt ist ein hohes Leistungsgewicht des Energieträgers von hervorragender Bedeutung.

Gemäß einer Ausgestaltung der Erfindung ist vorgesehen, dass das Anodenmaterial und das Kathodenmaterial gemischt in einer Matrix vorliegen, welche aus einem Kunststoff, insbesondere Polyvinylidenfluorid, kurz PVDF, oder Acrylnitril-Butadien-Styrol, kurz ABS, besteht.

Dadurch, dass das Material (also das Anodenmaterial und das Kathodenmaterial) in die Matrix eingebracht werden, ergibt sich vorteilhaft ein besonders stabiler Akkumulator-Verband. Außerdem kann der Kunststoff gleichzeitig den Elektrolyten ausbilden, der für eine Funktion des Akkumulators erforderlich ist. Dieser Elektrolyt ist auch im Betrieb vorteilhaft besonders sicher, da bei dem erfindungsgemäßen Akkumulator keine Flüssigkeiten austreten können (denn der Elektrolyt ist fest).

Gemäß einer Ausgestaltung der Erfindung ist vorgesehen, dass in der Matrix zusätzlich elektrisch leitfähige Partikel, insbesondere elektrisch leitfähig beschichtete Titanoxid-Nadeln oder Carbon-Nano-Tubes eingearbeitet sind.

Die Einbringung von zusätzlichen leitfähigen Partikeln hat den Vorteil, dass Batterieströme (laden und entladen) schneller fließen können. Hierdurch kann die durch das Konstruktionsprinzip von Anode und Kathode erreichbare Stromdichte auch zuverlässig aus dem Akkumulator abgeführt werden. Hierbei muss man sich nicht ausschließlich auf die in den Beschichtungen auf den Partikeln stattfindenden Tunneleffekte verlassen, sondern der elektrische Strom wird über die leitfähigen Partikel direkt geleitet. Um in dem Akkumulator ein elektrisch leitfähiges, zusammenhängendes Netzwerk zu erzeugen, ist es besonders vorteilhaft, wenn die elektrisch leitfähigen Partikel in einer Konzentration oberhalb der Perkolationsschwelle in das Material eingebracht werden. Die Perkolationsschwelle ist dadurch definiert, dass sich die benachbarten elektrisch leitfähigen Partikel in dem Akkumulator genügend oft berühren, damit der elektrische Strom über diese Partikel durch den gesamten Akkumulator geleitet werden können. Daher ist das Erreichen der Perkolationsgrenze auch dadurch definiert, dass die elektrische Leitfähigkeit eines Materials (hier des Akkumulators) sprunghaft ansteigt.

Gemäß einer Ausgestaltung der Erfindung ist vorgesehen, dass das Anodenmaterial und das Kathodenmaterial getrennte Lagen ausbilden, welche durch eine als Elektrolyt dienende Zwischenschicht voneinander getrennt sind.

Hierbei handelt es sich im Vergleich zu dem obenstehend erläuterten Akkumulator mit einer Kunststoffmatrix um einen Aufbau, bei dem die Zwischenlage die Funktion des Elektrolyten übernimmt. Dieser Aufbau ist vorteilhaft einfach herzustellen. Außerdem kann die Menge des benötigten Elektrolyts einfach durch die Wahl der Dicke der Zwischenschicht beeinflusst werden.

Gemäß einer Ausgestaltung der Erfindung ist vorgesehen, dass im Anodenmaterial und/oder im Kathodenmaterial zusätzlich Partikel, insbesondere elektrisch leitfähig beschichtete Titanoxid-Nadeln oder Carbon-Nano-Tubes eingearbeitet sind.

Mit dem beschriebenen Verfahren ist es also vorteilhaft möglich, einen Lithium-Ionen-Akkumulator gemäß der Erfindung mit den erfindungsgemäßen Materialien herzustellen. Daher eignet sich das Verfahren in besonderer Weise, um das geforderte Eigenschaftsprofil (hohe Leistungsdichte, geringes Leistungsgewicht) in einem Akkumulator zu verwirklichen.

Die Aufgabe wird alternativ mit dem eingangs angegebenen Anspruchsgegenstand (Verfahren) erfindungsgemäß auch dadurch gelöst, dass die Anode aus dem erfindungsgemäßen Material als Anodenmaterial und die Kathode aus dem erfindungsgemäßen Material als Kathodenmaterial hergestellt wird.

Gemäß einer Ausgestaltung der Erfindung ist vorgesehen, dass das Anodenmaterial und/oder das Kathodenmaterial gemischt in einer Matrix eingebracht werden, welche aus einem Kunststoff, insbesondere Polyvinylidenfluorid, kurz PVDF, oder Acrylnitril-Butadien-Styrol, kurz ABS, besteht.

Gemäß dieser Ausgestaltung der Erfindung ist es damit möglich, einen Aufbau des Akkumulators in der bereits beschriebenen Form zu erreichen. Danach befinden sich das Anodenmaterial und das Kathodenmaterial gemischt in einer Matrix aus Kunststoff, welche gleichzeitig den Elektrolyten darstellt.

Gemäß einer Ausgestaltung der Erfindung ist vorgesehen, dass das Anodenmaterial und/oder das Kathodenmaterial mittels eines additiven Fertigungsverfahrens, insbesondere Fused Filament Fabrication, kurz FFF, verarbeitet wird.

Diese Herstellungsweise ermöglicht es vorteilhaft, mittels FFF dreidimensionale Batteriestrukturen herzustellen, welche beispielsweis als Auskleidung von Gehäusen ausgeführt sein können. Hierdurch ist vorteilhaft eine besonders platzsparende Anordnung der so hergestellten Akkumulatoren möglich. Außerdem können mit dem Verfahren gute und gleichmäßige Mischungsverhältnisse des verarbeiteten Kunststoffs erreicht werden, weil die Partikel den verarbeiteten Filamenten direkt zugemischt werden können.

Gemäß einer Ausgestaltung der Erfindung ist vorgesehen, dass das Verfahren in einem Wirbelstromreaktor durchgeführt wird.

Bei dem Verfahren der Beschichtung in einem Wirbelstromreaktor handelt es sich um ein sogenanntes ALD-Verfahren. Die Materialien können aus Precursoren direkt aus der Gasphase abgeschieden werden, wobei sich sogar Monolagen von Atomen auf den Partikeln abscheiden lassen. Hierdurch sind hochpräzise Beschichtungsvorgänge möglich, wobei vorteilhaft Tunneleffekte zur Leitung des elektrischen Stroms und Aufrechterhaltung der Batteriefunktionen genutzt werden können. Dies ermöglicht vorteilhaft besonders hohe Stromdichten sowie ein geringes Leistungsgewicht der hergestellten Akkumulatoren.

Folgende weitere Vorteile lassen sich mit den erfindungsgemäßen Ausgestaltungen (Material, Lithium-Ionen-Akkumulator, Herstellungsverfahren) erreichen.

- Durch die Verwendung von Nadeln, Plättchen oder Flakes im Nano- oder Mikrobereich wird die Oberfläche des aktiven Materials vergrößert und kann dreidimensionale Strukturen annehmen.
- Elektrisch leitende Titandioxidnadeln sind bei mechanischer und thermischer Beschädigung der Lithium-Zellen sicherer als Graphit oder Graphen, da Titandioxid erst bei 1865 °C zu schmelzen beginnt und Graphit sich bei 600 °C unter Sauerstoffeinwirkung entzündet. Durch den Einsatz von Titandioxid wird eine Selbstentzündung und Explosion der Zelle vermieden.
- Titandioxidnadeln haben den Vorteil, dass aufgrund ihrer geometrischen Form weniger Material zum Einarbeiten in Bindemittel oder Polymerwerkstoffen (Polyvinylidenflourid, PVDF) benötigt wird als mit sphärischen Partikeln, da diese anisotrop dimensionalen Partikel ein leitfähiges Netzwerk ausbilden können.
- Das ALD-Verfahren begünstigt aufgrund seiner physikalischen und chemischen Vorgehensweise sehr dünne, homogene und konforme Beschichtungen mit der gewünschten Stöchiometrie und Mikrostruktur.
- Beim ALD-Verfahren begrenzen sich die Oberflächenreaktionen durch die Art der Prozessführung selbst, so dass die aktiven Materialien in Schichtdicke und Zusammensetzung kalkulierbar und reproduzierbar abgeschieden werden. Man kann die Ladungsmenge, den Energiegehalt, die Batteriekapazität und die Energiedichte genau einstellen.
- Schichtdicken im atomaren und Nanometerbereich ermöglichen Tunneleffekte und Hoppingmechanismen für die Elektronenleitung. Die Elektronen können schneller von einem lokalisierten Zustand in einem benachbarten springen, da die Abstände zwischen den Schichten und Partikeln kurz sind.
- Durch die Atomlagenabscheidung können die energiespeichernden und elektrochemisch aktiven Materialien nahtlos aneinandergefügt werden, so dass kaum ein Innenwiderstand zwischen den Materialien herrscht und der Ladungstransport (Elektronen und Ionen) ohne Hindernisse erfolgen kann.
- Die beschichteten Nadeln oder die beschichteten Kohlenstoffpartikel (Graphit, Graphen-Nanoplatelets und CNTs) können über die Einarbeitung in Kunststofffilamente (Polyvinylidenfluorid PVDF oder Acrylnitril-Butadien-Styrol ABS) im FFF-Druckverfahren (Fused Filament Fabrication) zur Herstellung von 3D-Batterien verwendet werden. Damit kann die Energiedichte und Leistungsdichte gedruckter Lithium-Ionen-Akkumulatoren erheblich verbessert werden. Somit wird beim Einsatz dieser beschichteten, leitenden Trägermaterialien beim 3D-Drucken die Elektrodenoberfläche dreifach vergrößert: 1. Formänderung der Elektrode von 2D nach 3D durch Verarbeitung eines 3D-CAD-Datenformats, 2. Verfahrenstechnisch bedingte Infill-Struktur der Volumenkörper beim FFF-Druckverfahren (Die Elektrodenoberfläche wird in sich noch einmal vergrößert), 3. Beschichtung von anisotrop dimensionalen, elektrisch leitfähigen Trägermaterialen über ALD-Verfahren.
- Eine Herstellung von kurzschlussfesten, nicht brennbaren, nicht explosiven, sowie nicht für einen Thermal Runaway (Überhitzung) anfälligen Zellen ist möglich.
- Die geometrische Form der Partikel (z.B. Nadeln, Flakes, Plättchen) bietet ein besseres Verhältnis von Oberfläche zu Volumen als sphärische Partikel. Diese Tatsache hilft bei der Mischung zum Beispiel in Polymerwerkstoffen. Die Oberfläche wird vergrößert, ohne dass man zu kleine Partikel benutzen muss.
- Man benötigt nur 1/3 bis 1/2 der Masse gegenüber sphärischen Partikeln.
- Herstellung von Hochenergiezellen durch den Einsatz der anisotrop dimensionalen Trägerpartikeln, weil auf die vergrößerten Partikeloberflächen mehr energiespeicherndes Material abgeschieden werden kann.
- Herstellung von Hochleistungszellen durch den Einsatz von ALD, weil die energiespeichernden und elektrochemisch aktiven Materialien in atomarer Schichtdicke abgeschieden werden können. Die Elektronen können bei den elektrochemischen Vorgängen sehr schnell ihre Zustände wechseln (Tunneleffekt).
- Durch die Zunahme der aktiven energiespeichernden Materialien wird die spezifische Energie (Energiedichte) in dem Akkumulator erhöht. Die Gesamtmenge an aktivem Material ist mit der Batteriekapazität (auch Nennkapazität genannt) verbunden und partizipiert an den elektrochemischen Reaktionen. Aus der Nennkapazität $C_n$ und der Nennspannung $U_n$ ($E = C_n * U_n$) ergibt sich der Energiegehalt (Watt h = 3,6 kJ) des Akkumulators. Wird der Zelle eine größere Menge an aktivem Material zur Verfügung gestellt und damit Ladungsmenge Q, die Batteriekapazität C und Energiegehalt E erhöht, können die Li-Ionen-Akkumulatoren leichter und flacher konzipiert werden. Für große Mengen an energiespeichernden Materialien gibt es kommerzielle Betreiber von ALD-Anlagen, die in der Lage sind, mehrere Tonnen pro Tag Trägermaterial mit den energiespeichernden und elektrochemisch aktiven Stoffen aus der Gasphase zu versehen.
- Die beschichteten Trägermaterialien (leitfähige Titandioxidnadeln, Graphit, CNTs, Graphen-Nanoplatelets) können in folgende Elektroden eingesetzt werden:

- Elektroden für die Elektrolyse von Wasser
- Elektroden für die Kohlenstoffdioxidverwertung, Kohlenstoffdioxid-Elektrolyse zur Herstellung von synthetischen Brenngasen ($CO_2$ to Value).

- Leitfähige Titandioxidnadeln werden mit schnell Elektronen leitenden Materialien (zum Beispiel atomare GermaniumSchicht) und für die Elektrolyse entsprechenden Katalysator nahtlos mittels ALD-Verfahren beschichtet, so dass die aktiven Katalysatorenzentren durch schnelle Elektronenübergänge effizient die elektrochemischen Reaktionen beschleunigen können.

- Die mit energiespeichernden Materialien beschichteten Titandioxidnadeln können in Polymerwerkstoffe (Polyvinylidenfluorid PVDF oder Acrylnitril-Butadien-Styrol ABS) eingearbeitet werden und zu einem Kunststofffaden weiter verarbeitet werden. Dieser Kunststofffaden kann dann im FFF-Druckverfahren (Fused Filament Fabrication) zur Herstellung von 3D-Akkumulatoren verwendet werden.

- Einsatz von Lithium-Ionen-Akkumulatoren mit hoher Energiedichte, Kapazität, Energiegehalt und Leistungsdichte in der modernen Fahrzeugtechnik (Auto, Flugzeug) durch deutliche Reduzierung von Gewicht und damit deutliche Erhöhung der Reichweite. Da die neuen aktiven Materialien beide Eigenschaften (hohe Energiedichte und hohe Leistungsdichte) vereinen, können auch die Energien, die aus mechanischen Vorgängen (Reibung, Bremsen) entstehen, schnell gespeichert werden. Damit wird auch ein Beitrag zur Verringerung der Energieverluste in der modernen Fahrzeugtechnik geleistet.

- Die neuen aktiven Materialien lassen sich auch als stationäre Speicher im Stromnetz zur Stabilisierung bei Stromschwankungen, insbesondere bei Nutzung von erneuerbaren Energien aus Wind und Sonne, verwenden. Auch eine 2nd-Life-Nutzung der neuen Materialien aus ausgedienten Flugzeug- und Elektrofahrzeugbatterien ist möglich.

Weitere Einzelheiten der Erfindung werden nachfolgend anhand der Zeichnung beschrieben. Gleiche oder sich entsprechende Zeichnungselemente sind jeweils mit den gleichen Bezugszeichen versehen und werden nur insoweit mehrfach erläutert, wie sich Unterschiede zwischen den einzelnen Figuren ergeben.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Es zeigen:

Figur 1 und Figur 2 Ausführungsbeispiele für Wirbelbettreaktoren (kurz FBR), mit denen ein Ausführungsbeispiel des erfindungsgemäßen Verfahrens durchgeführt werden kann, schematisch geschnitten,

Figur 3 bis Figur 6 Ausführungsbeispiele für Vorstufen zur Herstellung von Germanium auf den anodischen Partikeln jeweils als Strukturformeln,

Figur 7 bis Figur 9 Ausführungsbeispiele für Vorstufen zur Herstellung von Boroxid auf den anodischen Partikeln jeweils als Strukturformeln,

Figur 10 und Figur 11 Ausführungsbeispiele für Vorstufen zur Herstellung von Lithium auf den anodischen Partikeln, jeweils als Strukturformeln,

Figur 12 und Figur 13 Ausführungsbeispiel der erfindungsgemäßen Nadeln mit Anodenmaterial beschichtet, jeweils schematisch geschnitten,

Figur 14 bis Figur 24 Ausführungsbeispiele für Vorstufen zur Herstellung von Eisen auf den kathodischen Partikeln, jeweils als Strukturformeln,

Figur 25 und Figur 26 Ausführungsbeispiele für Vorstufen zur Herstellung von Silizium-Eisen-Phosphat, jeweils als Strukturformen,

Figur 27 ein Ausführungsbeispiel für ein kathodisches Nanopartikel in Form einer Titannadel, beschichtet, schematisch geschnitten,

Figur 28 bis Figur 32 Ausführungsbeispiele für Vorstufen zur Herstellung von Lithium Manganphosphat, jeweils als Strukturformeln,

Figur 33 und Figur 34 Ausführungsbeispiele von Lithium-Ionen-Akkumulatoren, bei denen die erfindungsgemäßen Nanopartikel zum Einsatz kommen, schematisch geschnitten.

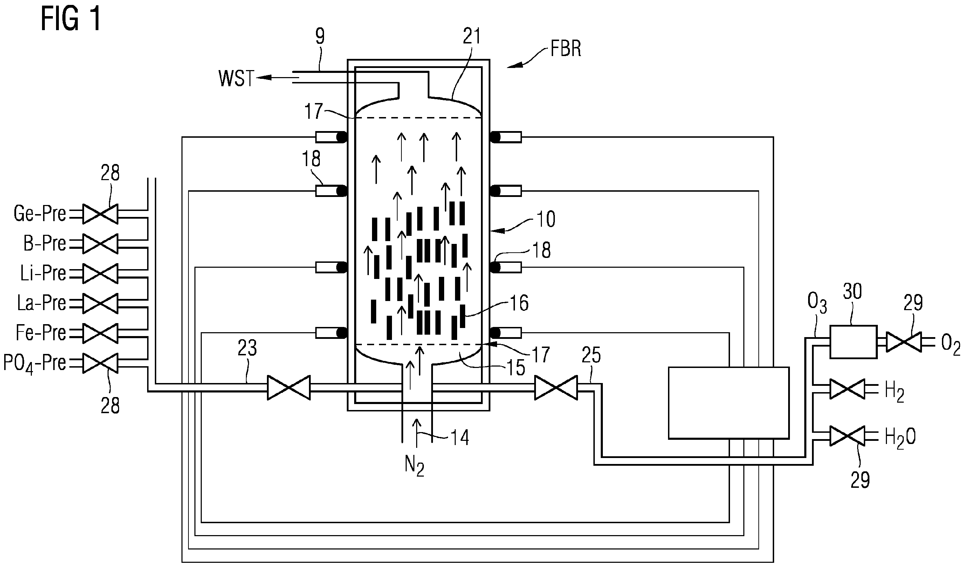

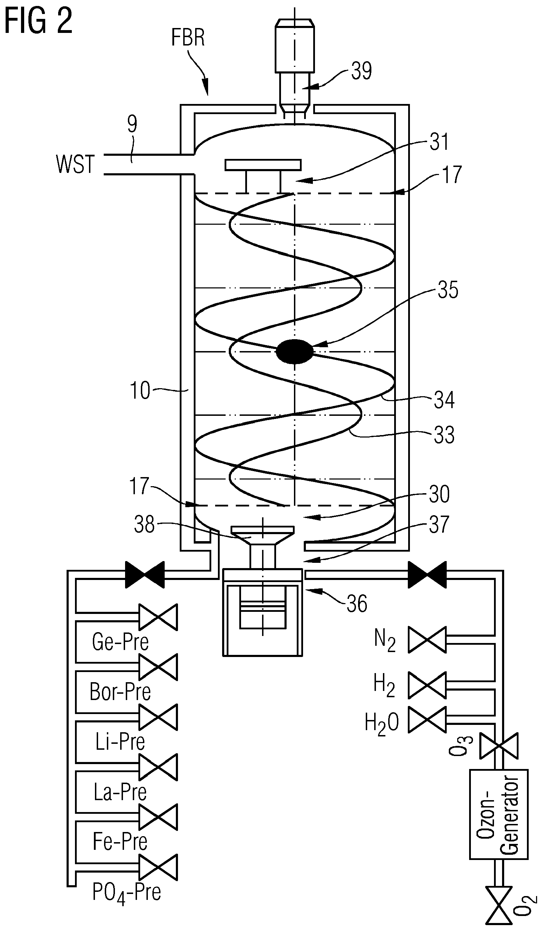

In den Figuren 1 und 2 sind Wirbelstromreaktoren dargestellt, mit denen die Nanopartikel, insbesondere die Titanoxidnadeln bzw. Graphen Flakes durch Atomlagenabscheidung beschichtet werden können. Hierbei lässt sich vorteilhaft die Dicke der abgeschiedenen Schichten genauestens steuern, wodurch die elektrischen Eigenschaften der hergestellten Nanopartikel vorteilhaft genau eingestellt werden können. Im Folgenden wird die Vorgehensweise in den Wirbelstromreaktoren anhand von Beispielen erläutert.

Erste Prozessabfolge:

Die Titandioxidnadeln werden in einem Wirbelstromreaktor (FBR, Fluidized Bed Reactor) gefüllt. Solch ein Wirbelstromreaktor ist in Figur 1 dargestellt. Das Gas 14, welches als Fluid agiert, tritt durch einen Verteiler 15, der am Boden einer Vakuumkammer 21 des Reaktors lokalisiert ist, in den Reaktor. Das Gas strömt aufwärts durch das Partikelbett und übt dabei eine nach oben gerichtete Kraft auf die Partikel 16 (Titanoxidnadeln) aus. Die Titandioxidnadeln würden sonst durch ihr Eigengewicht und die Gravitation nach unten gezogen werden. Der Gasstrom sollte so eingestellt werden, dass die nach oben und nach unten wirkenden Kräfte ausbalanciert sind und ein fluidisierter Zustand entsteht. Damit die Titandioxidnadeln nicht aus dem Reaktor gesaugt oder geblasen werden, befindet sich unten und oben im FBR je ein Partikelfilter 17. Das Trägergas wird durch einen Auslass 9 für Abgase WST aus dem Reaktor ausgetragen. In der Wand ist eine nicht näher dargestellte Heizung 10 vorgesehen.

Zur Überwindung der Agglomerationskräfte zwischen den Nadeln sind unterstützende Methoden notwendig, damit sich ein fluidisierter Zustand einstellt. Eine Vibration des Wirbelstrombetts kann durch Ultraschallgeber 18, die an der Außenwand des FBR's angebracht sind, und über einen Ultraschallgenerator 19 gesteuert und geregelt werden.

Befinden sich die Titandioxidnadeln im Reaktor, wird über eine Pumpe ein Feinvakuum von $10^{-3}$ mbar im Reaktor eingestellt. Das bedeutet, dass die Luft abgepumpt wird. Danach werden die Nadeln durch Inertgaseinführung in einen fluidisierten Zustand überführt. In dem fluidisierten Zustand wird der Reaktorraum über Wärmestrahlung auf 140 bis 230 °C erwärmt. Dazu befindet sich außerhalb des Reaktors eine Heizmanschette (nicht dargestellt). Die Precursoren werden in Bubblern (nicht dargestellt) als Schutz gegen Luftsauerstoff und Luftfeuchtigkeit aufbewahrt und über einen Thermostat auf 80 bis 90 °C erhitzt. Der Bubbler ist mit einem Zuleitungsrohr und einem Entnahmerohr ausgestattet. Über das Zuleitungsrohr gelangt Trägergas (Stickstoff) in den Bubbler und vermischt sich dort mit den Precursoren.

Die elektrisch leitfähigen Titandioxidnadeln sind in unterschiedlichen Längen- und Breitenverhältnisse bei der Firma Ishihara erhältlich (FT1000; Dicke: 0,13 $\mu$m, Länge: 1,68 $\mu$m, FT2000; Dicke 0,21 $\mu$m, Länge: 2,86 $\mu$m, FT3000; Dicke: 0,27 $\mu$m, Länge: 5,15 $\mu$m, spezifischer Widerstand: 10 bis 60 Ohm cm) .

Das Stickstoff-Precursordampf-Gemisch verlässt über den Entnahmerohr 23 den Bubbler und wird über Rohre pneumatisch mit Hilfe von Ventilen 28 in den FBR geleitet. Der Precursor-Strom in dem FBR wird durch den Dampfdruck des Precursors und den geregelten Durchfluss des N2-Trägergases so kontrolliert und gesteuert, dass eine Monolage des Precursors auf die Oberfläche der Titandioxid-Nadeln chemisorbiert wird.

In einem zweiten Schritt werden überschüssige Precursor-Gasmoleküle entfernt und der FB-Reaktor mit Stickstoff gespült. Im nächsten Schritt werden die entsprechenden Reaktanten (Wasser, Ozon oder Wasserstoff) in den FBR eingeleitet. Die Reaktanten reagieren sofort mit dem sorbierten Metall- oder Phosphat-Precursoren unter Bildung von Metall, Metalloxid oder Metallphosphat und den volatilen organischen Substituenten. Anschließend werden die volatilen Substituenten und die überschüssigen Reaktanten (Wasser, Ozon, Wasserstoff) abgepumpt. Dann werden der FBR-Raum und die beschichteten Nadeln mit Stickstoff gespült.

Zweite Prozessabfolge:

Um beispielsweise Graphen-Nanoplatelets und CNTs entgegen ihrer Schwerkraft in Schwebe zu halten, wird der ALD-Prozess durch Anwendung von Ultraschallwellen (akustische Levitation) unterstützt. Zur Umsetzung dieses Verfahrens ist ein Wirbelstromreaktor gemäß Figur 2 erforderlich (soweit dieser strukturell dem Aufbau des Reaktors gemäß Figur 1 entspricht, sind dieselben Bezugszeichen verwendet worden: siehe Beschreibung der Figur 1). Mit diesem lassen sich diese Partikel völlig frei durch den Raum bewegen und eine gleichmäßige Beschichtung aller Partikel wird erreicht.

Prinzip der akustischen Levitation ist der Stehwelleneffekt im Ultraschallfeld. Eine Ultraschallquelle 30 steht einem Reflektor 31 in einem Abstand L des ganzzahligen Vielfachen der halben Wellenlange $\lambda$ des Ultraschalls gegenüber:

$$L = n\ \lambda/2.$$

Unter diesen Bedingungen wird die ausgesandte Schallwelle auf sich selbst reflektiert und es entsteht eine stehende Welle. Diese besteht abwechselnd aus Gegenden großer Schallschnelle 33 (Knoten) und Gegenden großer Schalldrücke 34 (Bäuche). In den Konten dieser Welle können die Partikel 35 berührungslos positioniert werden.

Bei entsprechender Stärke des Ultraschallfeldes wird die Schwerkraft der Partikel 35 durch die Levitationskraft kompensiert. Dabei kehren die Partikel durch die strömungsmechanischen Effekte der hochfrequenten Gasbewegung immer wieder in das Zentrum des Knotens zurück. Die Kräfte, die die Partikel in den Druckknoten des stehenden Schallfeldes halten, werden in axialen und radialen Positionierungskräften unterschieden. Die axiale Positionierungskraft wirkt parallel zur Mittelachse des Feldes, die radiale Positionierungskraft senkrecht dazu.

Die Ultraschallquelle 30 kann beispielsweise eine Piezokeramik 36 aufweisen, die über einen Schallabsorber 37 die Schwingungen an einen Kolbenschwinger 38 abgibt. Dieser erzeugt die stehenden Wellen im Zusammenwirken mit dem Reflektor 31. Um die stehende Welle zu erzeugen, ist eine genaue Positionierung des Reflektors 31 gegenüber dem Kolbenschwinger 38 erforderlich. Zu diesem Zweck ist am Reaktor eine Mikrometerschraube 39 angeordnet.

Die beiden Kräfte stehen in einem Größenverhältnis von ca. 5:1 zueinander. Sie können bei geeigneter Stärke des Ultraschallfeldes eines passend dimensionierten Partikels kompensieren und sie am radialen und axialen Abwandern aus den Druckknoten hindern. Am Ort der Druckknoten existieren Potentialtöpfe, in denen die Partikel berührungslos positioniert und levitiert werden. Die Folge dieser Druckknoten sind Positionierungs- und Levitationskräfte. Die Positionierung eines Partikels hängt von der Dichte und Größe des Partikels, der Energiedichte und der Frequenz des stehenden Ultraschallfeldes, der Schallgeschwindigkeit im Proben- und im umgebenden Trägermedium sowie der Dimensionierung des akustischen Resonators ab. Die maximale Probengröße, die in einem akustischen Levitator stabil positioniert werden kann, ist abhängig von der Frequenz des stehenden Feldes.

Figur 2 zeigt den schematischen Aufbau eines Rohrreaktors mit einem Ultraschallevitator. Um hohe Schallintensitäten bei der akustischen Levitation zu erzeugen, wird ein piezoelektrischer Wandler verwendet. Als Piezoelemente werden Bariumtitanat oder Bleizirkontitanat verwendet. Durch Anlegen äußerer elektrischer Felder an die Piezokeramiken werden diese periodisch verformt. Diese mechanischen Dickenschwingungen müssen durch einen geeigneten mechanischen Aufbau (Horn) zur Verstärkung und Transformation der Amplitude auf das Trägermedium im Resonator des Ultraschallevitators, zum Beispiel Stickstoff, übertragen werden.

Am gegenüberliegenden Ende des Reaktors, oberhalb des Ultraschallwandlers ist der Reflektor 31 angebracht, um eine für die Levitation der Partikel notwendige stehende Schallwelle zu erhalten. Die ausgekoppelte Schallwelle wird in sich zurückreflektiert. Bei geeignetem Abstand von Ultraschallwandler 30 und Reflektor 31 bildet sich ein stehendes Ultraschallfeld. Ultraschallwandler und Reflektor ergeben einen akustischen Resonator. Die Resonatorlänge kann mit Hilfe einer Mikrometerschraube 39 am Reflektor variiert werden.

Die üblichen Arbeitsfrequenzen von Ultraschallevitatoren liegen im Bereich von 20 bis 100 kHz. Die Resonanzfrequenzen müssen experimentell bestimmt werden. Um die akustische Falle (Levitator) zu betreiben, ist dafür eine geeignete Anregungselektronik (nicht dargestellt) notwendig. Mit Hilfe eines Funktionsgenerators kann die akustische Falle zu sinusförmigen Schwingungen einer festen

Frequenz angeregt werden. Reicht der Sinusgenerator allein nicht aus, um die akustische Falle ausreichend mit elektrischer Leistung zu versorgen, ist extra ein für die Falle passender Leistungsverstärker erforderlich. Mit Hilfe eines Oszilloskops können die Ausgangsspannung $U_0$ des Sinusgenerators (was der Eingangsspannung am Verstärker entspricht) sowie die Ausgangsspannung $U_A$ oder die Ausgangstromstärke $I_A$ am Verstärker beobachtet und gemessen werden.

Herstellung des Anodenmaterials

Zur Herstellung des Anodenmaterials wird das elektrisch leitfähige Trägermaterial mit Germanium, Bor oder Boroxid und Lithium über Metallprecursoren aus der Dampfphase abgeschieden. Die Herstellungsschritte für die einzelnen werden folgenden der und durch Wortgleichungen veranschaulicht.

Erste Schicht: Germanium

Germanium steht im Periodensystem in der vierten Hauptgruppe unterhalb von Silizium, ist ein Halbmetall und wird zu den Halbleitern gezählt. Einatomige Schichten aus Germanium leiten die Elektronen 10 Mal schneller als Silizium. Aus diesem Grund wird auf das elektrisch leitende Trägermaterial Germanium atomar über das ALD- Verfahren abgeschieden, damit beim Entladen der Zelle die Elektronen schnell von den Lithium-Atomen in den externen Stromkreis fließen und umgekehrt beim Laden die Elektronen schnell von den Li-Ionen aus dem externen Stromkreis aufgenommen werden. Für Germanium können folgende Precursoren verwendet werden:

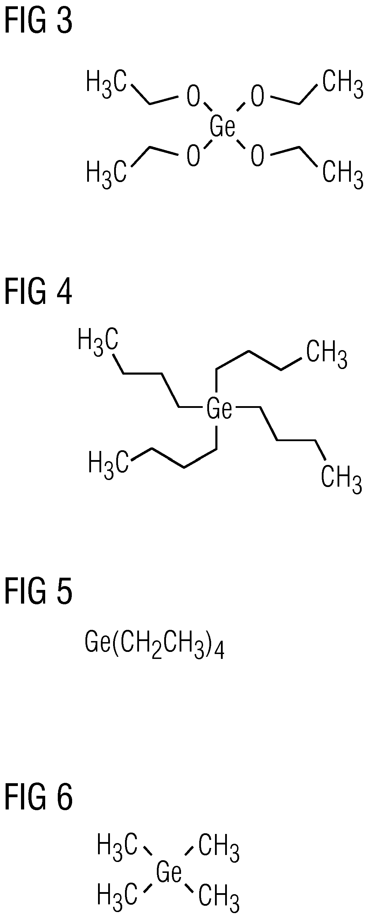

Germanium (IV)ethoxide gemäß Figur 3,
Tetra-n-butylgermane gemäß Figur 4,
Tetraethylgermane gemäß Figur 5,
Tetramethylgermane gemäß Figur 6.

Aufbringen am Beispiel von Tetra-n-butylgermane

Tetra-n-butylgerman hat einen Siedepunkt von 130 bis133 °C.

```
TiO₂ mit Sb/SnO₂ + Tetra-n-butylgermane = TiO₂ mit Sb/SnO₂
(Gleichung 1)
```

Evakuieren und Spülen mit Stickstoff, um überschüssiges Tetra-n-butylgerman zu entfernen

Einleiten von Wasserstoff: Als zweiten Reaktanten verwendet man Wasserstoff, um Butan vom Ge-Precursor abzuspalten und Germanium als Metall zu erhalten.

```
TiO₂ mit Sb/SnO₂ + 2H₂ = TiO₂ mit (Sb/SnO₂ und Ge) + 4 N-Butan
(Gleichung 2)
```

Evakuieren und Spülen mit Stickstoff, um N-Butan zu entfernen

Zweite Schicht: Bor oder Boroxid

Bor steht im Periodensystem in der dritten Hauptgruppe, zweite Periode und kann aufgrund seiner Elektronenkonfiguration $1s^2 2s^2 2p^1$ nur die drei Elektronen der zweiten Schale für die Ausbildung von kovalenten Bindungen zur Verfügung stellen. Dieser Elektronenmangel wird unter anderem durch ein Elektronenakzeptorverhalten kompensiert, daher zieht Bor die Elektronen vom Germanium an und erzeugt im Germanium positive Zentren. Durch die Ausbildung der positiven Zentren im Germanium und dem Elektronenmangel des Bors werden die Reduktions- und Oxidationsvorgänge der Lithiumatome beim Laden und Entladen an der Anode beschleunigt. Bor kann über folgende Precursoren abgeschieden werden:

Triisopropylborat,
Trimethylborat,
Triethylboran,
Bortriborid,
Bortrichlorid.

Aufbringen am Beispiel Triisopropylborat

Triisopropylborat hat einen Siedepunkt von 139 bis 141 °C und ist von den Bor-Precursoren am ungefährlichsten.

```
TiO₂ mit (Sb/SnO₂ und Ge) + Triisopropylborat = TiO₂ mit
(Sb/SnO₂ und Ge-Triisopropylborat)
(Gleichung 3)
```

Evakuieren und Spülen mit Stickstoff, um überschüssiges Triisopropylborat zu entfernen

Einleiten von Wasserstoff oder Wasserdampf: Als zweiten Reaktanten verwendet man Wasserstoff, um Isopropanol vom Bor-Precursor abzuspalten und Bor als Metall zu erhalten.

```
3 TiO₂ mit (Sb/SnO₂ und Ge) + 3 H₂ = 3 TiO₂ mit (Sb/SnO₂ und
Ge und B) + 3 Isopropanol
(Gleichung 4)
```

Bei Verwendung von Wasserdampf wird Boroxid gebildet und Isopropanol abgespalten. Lithium-Ionen können sich dann an das Boroxid als Lithiumtetraborate binden und somit die Anode vor Metallisierung mit Lithium schützen.

```
3 TiO₂ mit (Sb/SnO₂ und Ge) + 3H₂O = 3 TiO₂ mit (Sb/SnO₂ und
Ge und Boxid) + 3 Isopropanol
(Gleichung 5)
```

Evakuieren und Spülen mit Stickstoff, um Isopropanol zu entfernen

Dritte Schicht: Lithium

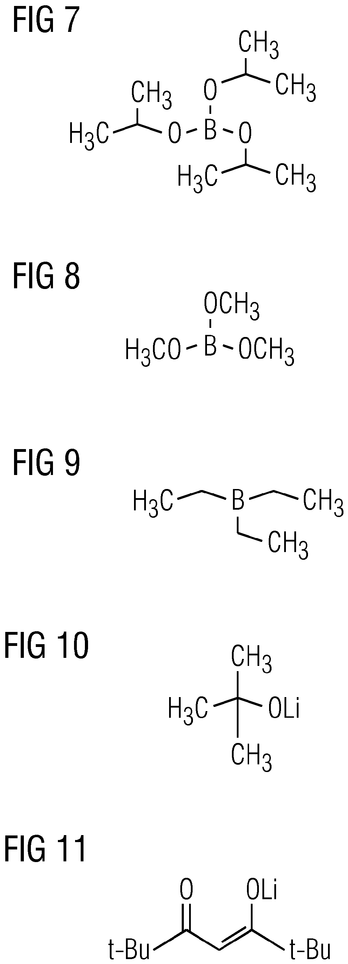

Lithium steht in der der ersten Hauptgruppe, zweite Periode, ist ein Leichtmetall, besitzt die geringste Dichte der festen Elemente, eine sehr niedriges Normalpotential, (das negativste Standardpotential aller Elemente) und bildet monovalente Ionen, die schnell diffundieren können. Aus den gennannten Gründen ist Lithium in wiederaufladbaren Batterien als Träger der chemischen Energie sehr gut geeignet. Als Lithium-Precursoren kommen in Betracht: Lithiumtert-butoxid gemäß Figur 10, 2,2,6,6-Tetramethyl-3,5-heptanedionatolithium gemäß Figur 11.

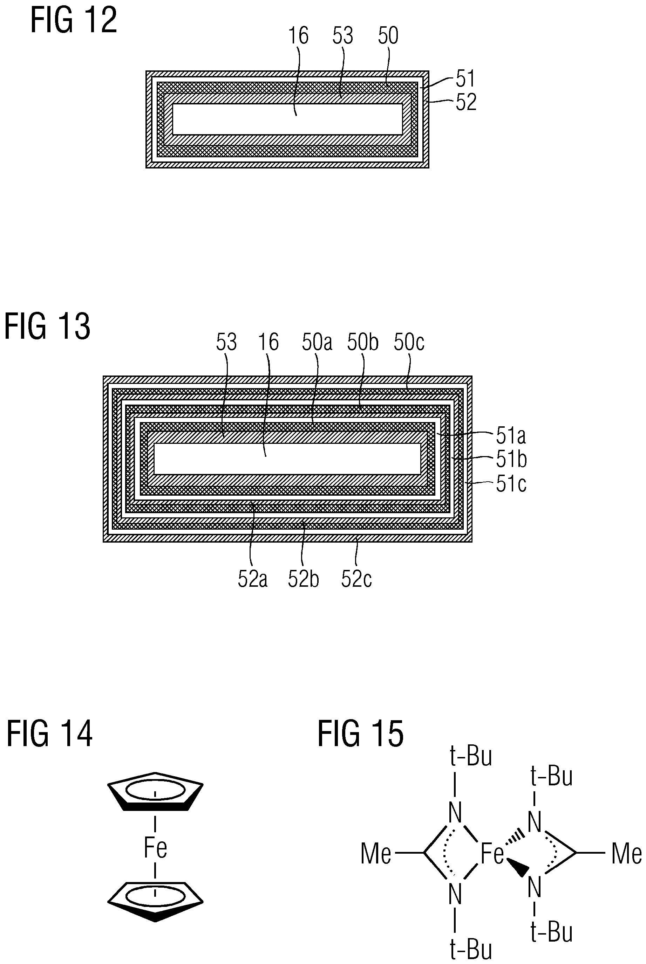

In Figur 12 ist ein Partikel 16 in Form einer Titanoxidnadel dargestellt, welches mit vier aufeinanderfolgenden Schichten beschichtet ist. Wie bereits erwähnt, befindet sich auf dem (elektrisch leitend beschichteten) Partikel 16 zunächst eine Germaniumschicht 50, die in der beschriebenen Weise hergestellt wurde. Dieser Schicht folgt eine zweite Schicht 51 aus Bor (oder Boroxid) und eine dritte Schicht 52 aus Lithium. Hierdurch entsteht ein Partikel, welches als anodisches Batteriematerial zum Einsatz kommen kann.

Gemäß Figur 13 ist dargestellt, dass das Partikel 16 in Form einer Titanoxidnadel auch mit einer Multilayerschicht von alternierenden Lagen aufgebaut sein kann. Abwechselnd sind Lagen 50a bis 50c aus Germanium, Lagen 51a bis 51c aus Bor und Lagen 52a bis 52c aus Lithium auf dem Partikel aufgebracht.

Da die Partikel 16 aus Titanoxid bestehen und elektrisch leitfähige Oberfläche auf dem Partikel vonnöten ist, ist außerdem eine elektrische Leitschicht 53 auf die Oberfläche der Partikel 16 gemäß Figur 12 und Figur 13 aufgebracht. Diese kann beispielsweise aus SB oder SnO2 bestehen.

Aufbringen von 2,2,6,6-Tetramethyl-3,5-heptanedionatolithium

Als Ausführungsbeispiel wird ausgewählt: 2,2,6,6-Tetramethyl-3,5-heptanedionatolithium. Dieser Li-Precursor hat einen Siedepunkt von 180 °C und ist von den Li- Precursoren am ungefährlichsten.

```
TiO₂ mit (Sb/SnO₂ und Ge und Boxid) + 2,2,6,6-Tetramethyl-
3,5-heptanedionatolithium = TiO₂ mit (Sb/SnO₂ und Ge und
Boxid und 2,2,6,6-Tetramethyl-3,5-heptanedionatolithium)
(Gleichung 6)
```

Evakuieren und Spülen mit Stickstoff, um überschüssiges 2,2,6,6-Tetramethyl-3,5-heptanedionatolithium zu entfernen Einleiten von Wasserstoff

Als zweiten Reaktanten verwendet man Wasserstoff, um den organischen Teil der Verbindung abzuspalten und metallisches Lithium auf der Trägeroberfläche zu erhalten.

$$2TiO_2 \text{ mit (Sb/SnO}_2 \text{ und Ge und Boxid)} + H_2 = 2\ TiO_2 \text{ mit}$$

$$\text{(Sb/SnO}_2 \text{ und Ge und Boxid und Li)} + 2\ 2,2,6,6\text{-Tetramethyl-}$$

$$3,5\text{-heptanedione}$$

(Gleichung 7)

Evakuieren und Spülen mit Stickstoff, um das Diketon zu entfernen.

Herstellung des Kathodenmaterials

Für eine wiederaufladbare Batterie wird als Kathodenmaterial Lithiummetalloxid oder Lithiummetallphosphat benötigt. Hinsichtlich der Explosionsgefahr, die von Lithiummetalloxidhaltigen Kathoden beim Laden durch Selbsterwärmung der Zelle (Thermal Runaway) ausgehen können, werden vorzugsweise die Lithiummetallphosphate ausgewählt. Zu den Lithiummetallphosphaten zählen Lithiumeisenphosphat, Lithiummanganphosphat, Lithiumcobaltphosphat und Lithiumnickelphosphat. Wegen des geringen Massenanteils und der geringen Rohstoffpreise wählen wir insbesondere die Abscheidung von Lithiumeisenphosphat oder Lithiummanganphosphat auf einen elektrisch leitenden Träger über Atomlagenabscheidung aus der Gasphase. Eisen und Mangan sind leichter, kommen in der Natur häufiger vor und sind damit preiswerter als Kobalt und Nickel. Folgender Ablauf gilt für die Prozessschritte:

Erster Schritt: Eisen

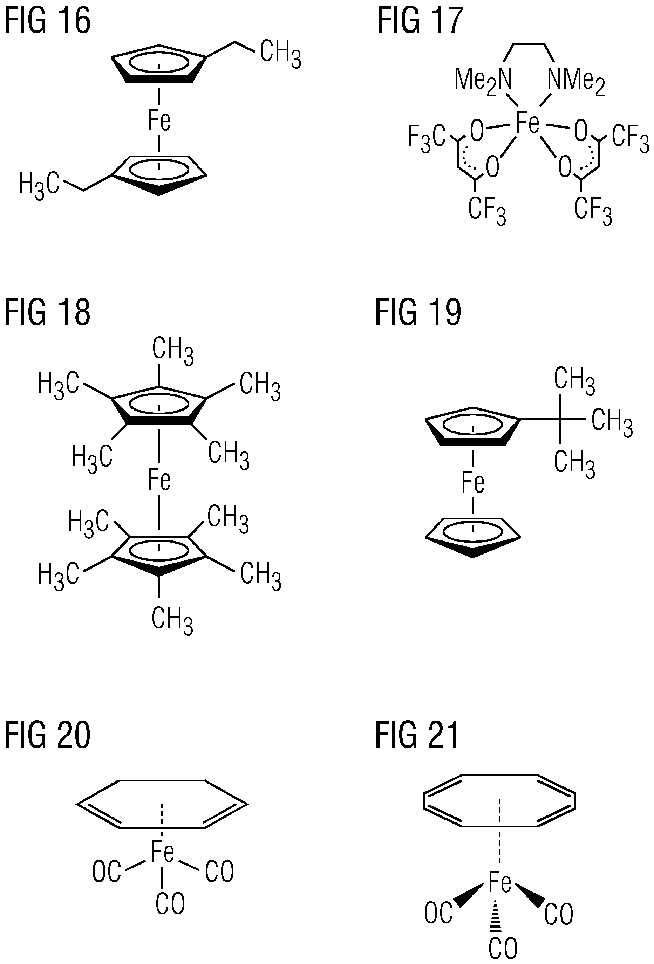

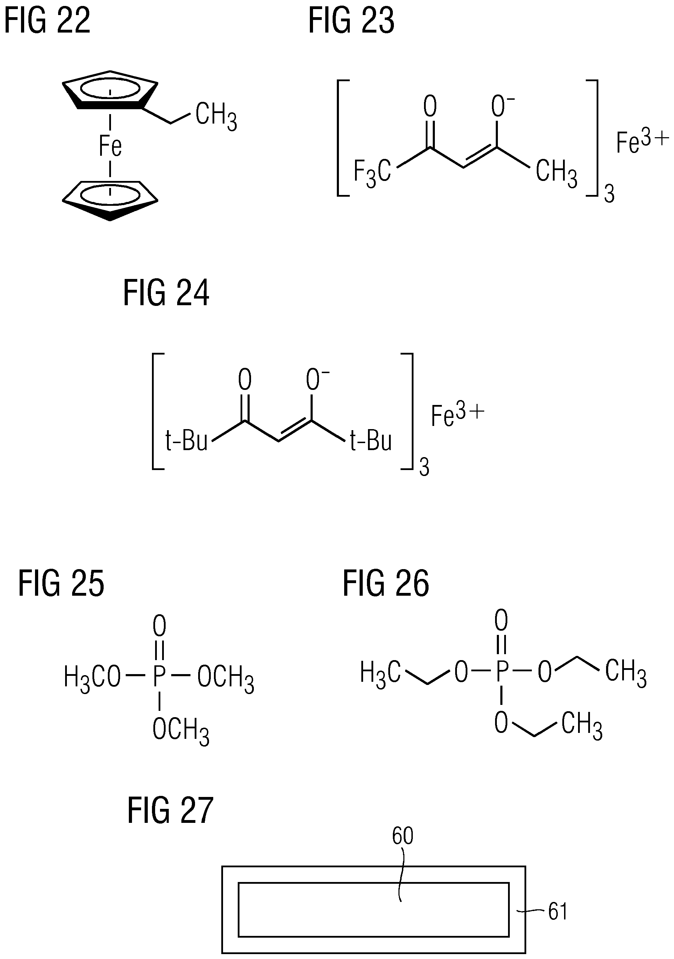

Folgende Precursoren für Eisen können verwendet werden: Bis(cyclopentadienyl)iron gemäß Figur 14, Bis(N,N'-di-t-butylacetamidinato)iron (II) gemäß Figur 15, Bis(ethylcyclopentadienyl)iron gemäß Figur 16, Bis(1,1,1,5,5,5-hexafluoroacetylacetonato) (N,N,N',N'-tetramethylethylenediamine)iron(II) gemäß Figur 17, Bis(pentamethylcyclopentadienyl)iron gemäß Figur 18, Bis(i-propylcyclopentadienyl) iron, Tert-Butylferrocene gemäß Figur 19, (Cyclohexadiene)iron tricarbonyl gemäß Figur 20, Cyclooctatetraene iron tricarbonyl gemäß Figur 21, Ethylferrocene gemäß Figur 22, Iron pentacarbonyl, Iron (III) trifluoroacetylacetonate gemäß Figur 23, Tris(2,2,6,6-tetramethyl-3,5- heptanedionato)iron (III) gemäß Figur 24.

Aufbringen von Bis (cyclopentadienyl) iron

$$TiO2 \text{ mit Sb/SnO2} + Bis(cyclopentadienyl)\ iron\ =\ TiO2 \text{ mit}$$

$$\text{(Sb/SnO2 und Bis (cyclopentadienyl) iron)}$$

Evakuieren und Spülen mit Stickstoff, um überschüssiges Bis(cyclopentadienyl)iron zu entfernen.

Einleiten von Ozon

Umsetzen von Bis(cyclopentadienyl)iron mit Ozon, um Eisenoxid mit einer Sauerstoffradikal-terminierte Oberfläche zu erzeugen und den organischen Substituenten, Cyclopentadien zu entfernen.

$$TiO_2 \text{ mit (Sb/SnO}_2 \text{ und Bis(cyclopentadienyl)iron)} + O_3 = TiO_2$$

$$\text{mit (Sb/SnO}_2 \text{ und FeO}_3) + 2\ Cyclopentadienyl$$

(Gleichung 8)

Evakuieren und Spülen mit Stickstoff, um überschüssiges Ozon und Cyclopentadien zu entfernen

Zweiter Schritt: Herstellung der Phosphate

Zur Abscheidung von Phosphat werden Phosphorsäureester als Precursoren verwendet, insbesondere
Trimethylphosphat gemäß Figur 25,
Triethylphosphat gemäß Figur 26,
Phosphor(V)-oxychlorid (POCl3)

Einleiten des Phosphorsäureesters, Trimethylphosphat TMPO

$$TiO_2 \text{ mit } (Sb/SnO_2 \text{ } FeO_3 + TMPO) = TiO_2 \text{ mit } (Sb/SnO_2 \text{ und } FeO_3 - TMPO)$$
$$(\text{Gleichung } 9)$$

Evakuieren und Spülen mit Stickstoff, um überschüssiges TMPO zu entfernen

Einleiten von Wasser und Ozon

Bildung von Eisenphosphat

$$2FeO_3 + 2 \text{ Trimethylphosphat} + 3 H_2O + O_3 = 2FePO_4 + 6CH_3OH + 3O_2$$
$$(\text{Gleichung } 10)$$

Evakuieren und Spülen mit Stickstoff, um Methanol und Sauerstoff zu entfernen

Dritter Schritt: Lithium

Aufbringen von 2,2,6,6-Tetramethyl-3,5-heptanedionatolithium.

$$TiO_2 \text{ mit } (Sb/SnO_2 \text{ UND } FePO_4) + 2,2,6,6\text{-Tetramethyl-3,5-heptanedionatolithium} = TiO_2 \text{ mit } (Sb/SnO_2 \text{ } FePO_4 \text{ und } 2,2,6,6\text{-Tetramethyl-3,5-heptanedionatolithium})$$
$$(\text{Gleichung } 11)$$

Evakuieren und Spülen mit Stickstoff, um überschüssiges 2,2,6,6-Tetramethyl-3,5-heptanedionatolithium zu entfernen

Einleiten von Wasserstoff

Als zweiten Reaktanten verwendet man Wasserstoff, um den organischen Teil der Verbindung abzuspalten und metallisches Lithium auf der Trägeroberfläche zu erhalten.

$$2TiO_2 \text{ mit } (Sb/SnO_2 \text{ und } FePO_4 \text{ und } 2,2,6,6\text{-Tetramethyl-3,5-heptanedionatolithium}) + H2 = 2 \text{ } TiO_2 \text{ mit } (Sb/SnO_2 \text{ und } FePO_4 \text{und } Li) + 2 \text{ } 2,2,6,6\text{-Tetramethyl-3,5- heptanedione}$$
$$(\text{Gleichung } 12)$$

Evakuieren und Spülen mit Stickstoff, um das Diketon zu entfernen

Die beschriebenen Abscheidungs- und Spül/Evakuierungsprozesse zwischen den schichterzeugenden Schritten bilden einen Abscheidungszyklus, der mehrmals wiederholt werden kann, bis die gewünschte Schichtdicke des $LiFePO_4$ erreicht ist. Die Adsorptionszeit der Precursoren für Eisen, Phosphat und Lithium, sowie der Reaktionsgase Ozon, Wasserdampf und Wasserstoff, die Spaltungszeit in Eisenphosphat und in die Zerfallsprodukte der organischen Liganden, sowie die Spülzeiten zwischen den schichtbildenden Vorgängen liegen in der Größenordnung von Sekunden. Figur 27 zeigt eine leitfähige $TiO_2$-Nadel 60 als Partikel (vgl. 16 in Figur 1) mit einer abgeschiedenen $LiFePO_4$-Schicht 61.

Lithiummanganphosphat

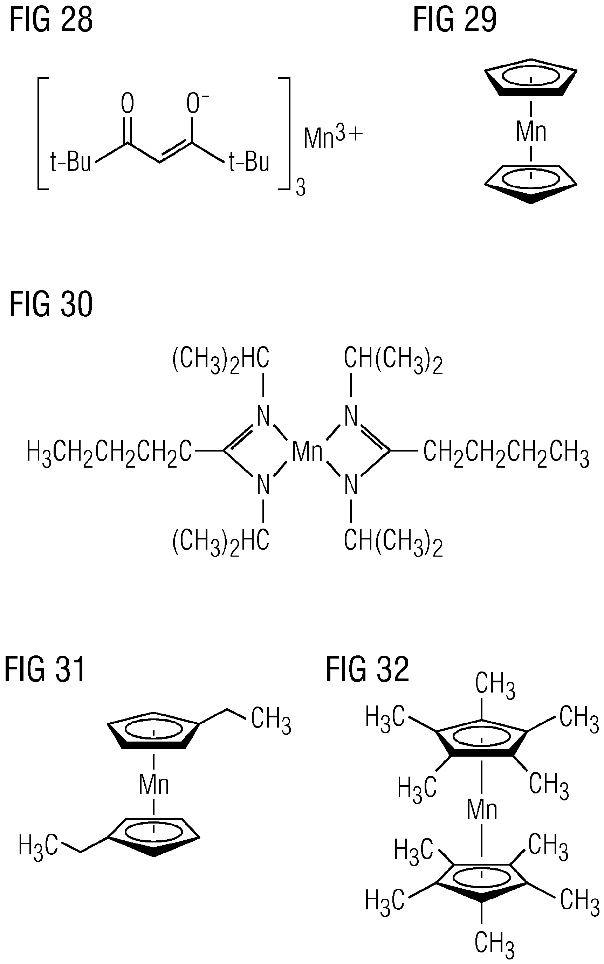

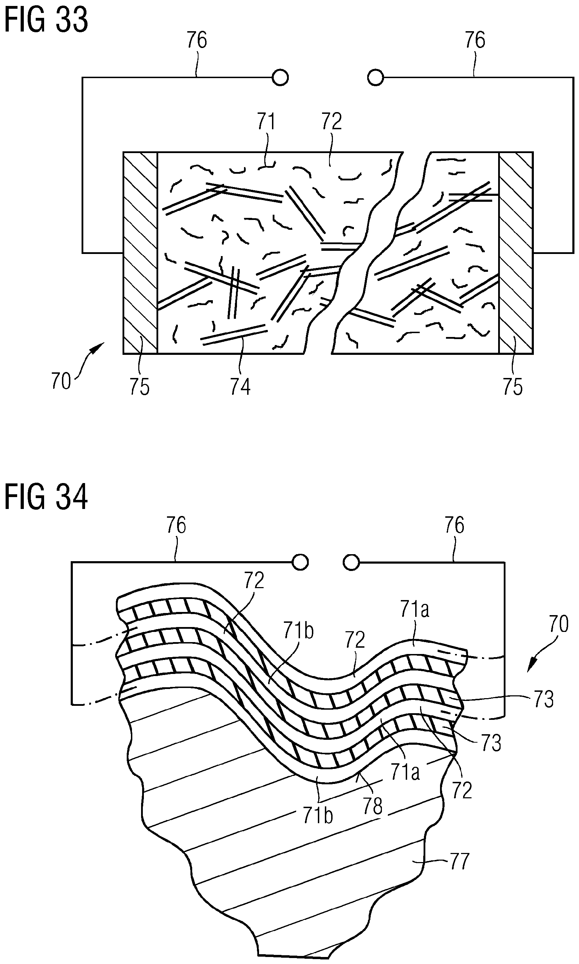

Anstelle von Lithiumeisenphosphat kann als Kathodenmaterial auch Lithiummanganphosphat verwendet werden und auf die genannten leitenden Trägermaterialien abgeschieden werden. Die Beschichtung des Trägermaterials erfolgt entsprechend der Abscheidung von Lithiumeisenphosphat in den vorgenannten Schritten Anstelle der genannten Eisen-Precursoren können folgende Mangan- Precursoren verwendet werden: Tris(2,2,6,6-tetramethyl-3,5-heptanedionato) manganese(III) gemäß Figur 28, Bis(cyclopentadienyl)manganese(II)gemäß Figur 29, Bis(N,N'-di-i-propylpentylamidinatomanganese(II) gemäß Figur 30, Bis(ethylcyclopentadienyl)manganese(II) gemäß Figur 31, Bis(pentamethylcyclopentadienyl)manganese(II) gemäß Figur 32. Gemäß Figur 33 und 34 sind Beispiele für erfindungsgemäße Lithium-Ionen-Akkumulatoren 70 dargestellt. Diese weisen jeweils das erfindungsgemäße Material 71, 71a, 71b auf, welches gemäß Figur 33 als Gemisch in einer Matrix 72 aus Polymerwerkstoff eingebettet und gemäß Figur 34 ein anodisches Material 71a und ein kathodisches Material 71b ausbildet, wobei die Materialien 71a, 71b durch Zwischenschichten 72 jeweils getrennt werden. Auch die Materialien 71a, 71b sind jeweils in einer Matrix 72 gebunden.

In der Matrix 72 gemäß Figur 33 sind außerdem zusätzliche Partikel 74, die elektrisch leitfähig sind, verteilt. Diese weiteren Partikel 74 weisen eine Konzentration oberhalb der Parkolationsschwelle auf, sodass ein elektrisch leitendes Netzwerk in der Matrix 72 ausgebildet ist, welches eine elektrische Verbindung zwischen Elektrodenschichten 75 ausbildet. Die Elektrodenschichten 75 können mit elektrischen Anschlüssen 76 verbunden werden, welche als Batteriepole genutzt werden können.

Auch der Akku gemäß Figur 34 weist die Anschlüsse 76 auf. Diese sind wechselseitig mit den Lagen verbunden, welche mit den anodischen Partikeln 71a beziehungsweise mit den kathodischen Partikeln 71b ausgestattet sind. Die Verbindung ist lediglich durch eine Stichpunktlinie angedeutet.

Außerdem befindet sich der Akku 70 gemäß Figur 34 auf einem Bauteil 77, welches nur als Ausschnitt dargestellt ist. Es wird deutlich, dass der Akku einer Kontur 78 dieses Bauteils 77 folgt. Der Akku 70 kann beispielsweise in nicht dargestellter Weise durch Filament Fusion Fabrication (FFF) auf die Kontur 78 des Bauteils 77 aufgetragen werden.

Bezugszeichenliste

| 16 | Partikel |
| 50 | Germaniumschicht |
| 51 | zweite Schicht Bor |
| 52 | dritte Schicht Lithium |
| 53 | elektrische Leitschicht |
| 70 | Lithium-Ionen-Akkumulatoren |
| 71 | Material |
| 71a | anodisches Material |
| 71b | kathodisches Material |
| 72 | Matrix |
| 74 | zusätzliche Partikel |
| 75 | Elektrodenschichten |
| 76 | elektrische Anschlüsse |
| 77 | Bauteil |
| 78 | Kontur |

**Patentansprüche**

1. Material für einen Lithium-Ionen-Akkumulator (70)
   **dadurch gekennzeichnet,**
   **dass** dieses zumindest an ihrer Oberfläche elektrisch leitfähige Mikropartikel oder Nanopartikel aufweist, welche mit mindestens einer funktionalen Schicht zur Ausbildung der kathodischen oder anodischen Funktion des Lithium-Ionen-Akkumulators (70) beschichtet ist.

2. Material nach Anspruch 1,

**dadurch gekennzeichnet,**
**dass** die Mikropartikel oder Nanopartikel aus Graphit, elektrisch leitfähig beschichtetem Titanoxid, Carbon-Nanotubes oder Graphen-Nanoplatelets bestehen.

3. Material nach einem der voranstehenden Ansprüche,
**dadurch gekennzeichnet,**
**dass** die Mikropartikel oder Nanopartikel die Form von Nadeln, Flakes oder Plättchen haben.

4. Material nach einem der voranstehenden Ansprüche,
**dadurch gekennzeichnet,**
**dass** die mindestens eine funktionale Schicht eine Dicke von weniger als 500 nm aufweist, vorzugsweise die Dicke einer Atomlage aufweist.

5. Material nach einem der voranstehenden Ansprüche,
**dadurch gekennzeichnet,**
**dass** die Mikropartikel oder Nanopartikel für die Anode des Lithium-Ionen-Akkumulators (70) vorgesehen sind, wobei diese mehrere Schichten in der folgenden Reihenfolge von innen nach außen aufweisen, bestehend aus

- Germanium (50),
- Bor oder Boroxid (51),
- Lithium (52).

6. Material (71) nach einem der Ansprüche 1 bis 4,
**dadurch gekennzeichnet,**
**dass** die Mikropartikel oder Nanopartikel für die Kathode eines Lithium-Ionen-Akkumulators (70) vorgesehen sind, wobei diese aus einem Lithiummetalloxid oder Lithiummetallphosphat besteht.

7. Lithium-Ionen-Akkumulator (70) mit einer Anode und einer Kathode,
**dadurch gekennzeichnet,**
**dass** die Anode aus einem Material (71) gemäß Anspruch 5 als Anodenmaterial und die Kathode aus einem Material (71) gemäß Anspruch 6 als Kathodenmaterial gebildet ist.

8. Lithium-Ionen-Akkumulator (70) nach Anspruch 7,
**dadurch gekennzeichnet,**
**dass** das Anodenmaterial und das Kathodenmaterial gemischt in einer Matrix vorliegen, welche aus einem Kunststoff, insbesondere Polyvinylidenfluorid, kurz PVDF, oder Acrylnitril-Butadien-Styrol, kurz ABS, besteht.

9. Lithium-Ionen-Akkumulator nach Anspruch 8,
**dadurch gekennzeichnet,**
**dass** das in der Matrix (72) zusätzlich elektrisch leitfähige Partikel (74), insbesondere elektrisch leitfähig beschichtete Titanoxid-Nadeln oder Carbon-Nano-Tubes eingearbeitet sind.

10. Lithium-Ionen-Akkumulator (70) nach Anspruch 7,
**dadurch gekennzeichnet,**
**dass** das Anodenmaterial (71a) und das Kathodenmaterial (71b) getrennte Lagen ausbilden, welche durch eine als Elektrolyt dienende Zwischenschicht voneinander getrennt sind.

11. Lithium-Ionen-Akkumulator (70) nach Anspruch 10,
**dadurch gekennzeichnet,**
**dass** im Anodenmaterial (71a) und/oder im Kathodenmaterial (71b) zusätzliche Partikel (74), insbesondere elektrisch leitfähig beschichtete Titanoxid-Nadeln oder Carbon-Nano-Tubes eingearbeitet sind.

12. Verfahren zum Herstellen eines Lithium-Ionen-Akkumulators (70),
**dadurch gekennzeichnet,**
**dass** die Anode aus einem Material (71) gemäß Anspruch 5 als Anodenmaterial (71a) und die Kathode aus einem Material (71) gemäß Anspruch 6 als Kathodenmaterial (71b) hergestellt wird.

13. Verfahren nach Anspruch 12,

**dadurch gekennzeichnet,**
**dass** das Anodenmaterial (71a) und/oder das Kathodenmaterial (71b) gemischt in einer Matrix (72) eingebracht werden, welche aus einem Kunststoff, insbesondere Polyvinylidenfluorid, kurz PVDF, oder Acrylnitril-Butadien-Styrol, kurz ABS, besteht.

14. Verfahren nach Anspruch 13,
**dadurch gekennzeichnet,**
**dass** das Anodenmaterial (71a) und/oder das Kathodenmaterial (71b) mittels eines additiven Fertigungsverfahrens, insbesondere Fused Filament Fabrication, kurz FFF, verarbeitet wird.

15. Verfahren nach Anspruch 12,
**dadurch gekennzeichnet,**
**dass** das Verfahren in einem Wirbelstromreaktor durchgeführt wird.

FIG 1

EP 3 629 405 A1

FIG 2

FBR

9

WST

39

31

17

35

10

34

33

17

30

38

37

36

Ge-Pre

Bor-Pre

Li-Pre

La-Pre

Fe-Pre

PO₄-Pre

N₂

H₂

H₂O

O₃

Ozon-Generator

O₂

## FIG 3

## FIG 4

## FIG 5

$Ge(CH_2CH_3)_4$

## FIG 6

FIG 7

FIG 8

FIG 9

FIG 10

FIG 11

FIG 12

16  53  50

51
52

FIG 13

53  16  50a  50b  50c

51a
51b
51c

52a  52b  52c

FIG 14

Fe

FIG 15

t-Bu

t-Bu

N

N

Me

Fe

Me

N

N

t-Bu

t-Bu

# FIG 16

# FIG 17

# FIG 18

# FIG 19

# FIG 20

# FIG 21

## FIG 22

## FIG 23

## FIG 24

## FIG 25

## FIG 26

## FIG 27

FIG 28

FIG 29

FIG 30

FIG 31

FIG 32

# FIG 33

# FIG 34

**EP 3 629 405 A1**

Europäisches Patentamt
European Patent Office
Office européen des brevets

# EUROPÄISCHER RECHERCHENBERICHT

Nummer der Anmeldung

EP 19 19 6978

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 8 968 820 B2 (NANOTEC INSTRUMENTS, INC.) 3. März 2015 (2015-03-03) | 1-4,6 | INV. H01M4/36 |
| A | * Abbildungen 1(B),3(B)-3(D),13 * * Spalte 4, Zeile 46 - Spalte 7, Zeile 35 * * Beispiele 18,19 * * Ansprüche 1-15 * ----- | 5,7-15 | H01M4/62 H01M4/58 H01M4/75 H01M4/13 H01M4/134 H01M10/0525 |
| X | US 2012/088154 A1 (LIU JUN [US] ET AL) 12. April 2012 (2012-04-12) | 1-4 | ADD. |
| A | * Ansprüche 1-23 * * Absatz [0004] - Absatz [0005] * * Absatz [0006] - Absatz [0007] * ----- | 5-15 | H01M4/04 |
| X | DE 10 2008 063552 A1 (VARTA MICROBATTERY GMBH [DE]) 10. Juni 2010 (2010-06-10) | 1-4 | |
| A | * Absatz [0001] * * Ansprüche 1-15 * * Absatz [0025] * * Absatz [0012] * * Absatz [0013] * ----- | 5-15 | |
| | | | **RECHERCHIERTE SACHGEBIETE (IPC)** |
| A | DE 10 2011 112948 B3 (UNIV HANNOVER [DE]) 6. Dezember 2012 (2012-12-06) * das ganze Dokument * * Absatz [0007] * * Absatz [0011] - Absatz [0012] * ----- | 1-15 | H01M |
| A | US 2010/000441 A1 (JANG BOR Z [US] ET AL) 7. Januar 2010 (2010-01-07) * das ganze Dokument * ----- | 1-15 | |

Der vorliegende Recherchenbericht wurde für alle Patentansprüche erstellt

| Recherchenort | Abschlußdatum der Recherche | Prüfer |
|---|---|---|
| München | 31. Januar 2020 | Kuhn, Tanja |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

25

**ANHANG ZUM EUROPÄISCHEN RECHERCHENBERICHT**
**ÜBER DIE EUROPÄISCHE PATENTANMELDUNG NR.**

EP 19 19 6978

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

31-01-2020

| Im Recherchenbericht angeführtes Patentdokument | Datum der Veröffentlichung | Mitglied(er) der Patentfamilie | Datum der Veröffentlichung |
|---|---|---|---|
| US 8968820 B2 | 03-03-2015 | KEINE | |
| US 2012088154 A1 | 12-04-2012 | CN 103155243 A | 12-06-2013 |
| | | EP 2625735 A2 | 14-08-2013 |
| | | JP 2013539193 A | 17-10-2013 |
| | | KR 20130119432 A | 31-10-2013 |
| | | US 2012088154 A1 | 12-04-2012 |
| | | US 2014203469 A1 | 24-07-2014 |
| | | WO 2012047329 A2 | 12-04-2012 |
| DE 102008063552 A1 | 10-06-2010 | CN 102239585 A | 09-11-2011 |
| | | DE 102008063552 A1 | 10-06-2010 |
| | | EP 2364511 A1 | 14-09-2011 |
| | | JP 5779101 B2 | 16-09-2015 |
| | | JP 2012511224 A | 17-05-2012 |
| | | KR 20110100209 A | 09-09-2011 |
| | | US 2011309310 A1 | 22-12-2011 |
| | | WO 2010063480 A1 | 10-06-2010 |
| DE 102011112948 B3 | 06-12-2012 | DE 102011112948 B3 | 06-12-2012 |
| | | WO 2013037879 A1 | 21-03-2013 |
| US 2010000441 A1 | 07-01-2010 | US 2010000441 A1 | 07-01-2010 |
| | | US 2012007913 A1 | 12-01-2012 |
| | | US 2016360616 A1 | 08-12-2016 |
| | | US 2019380201 A1 | 12-12-2019 |

EPO FORM P0461

Für nähere Einzelheiten zu diesem Anhang : siehe Amtsblatt des Europäischen Patentamts, Nr.12/82